# EUROPÄISCHE PATENTANMELDUNG

(11) **EP 1 843 279 A1**
(43) Veröffentlichungstag der Anmeldung: **10.10.2007**
(21) Anmeldenummer: 07005773.2
(22) Anmeldetag: 21.03.2007
(51) Int. Cl.: G06K 19/077

(54) **Applikation von elektronischen Bauelementen in Druckprodukten**

(30) Priorität: 04.04.2006 DE 102006016063; 14.02.2007 DE 102007007269
(71) Anmelder: MAN Roland Druckmaschinen AG, 63075 Offenbach (DE); Printed Systems GmbH, 09120 Chemnitz (DE)
(72) Erfinder: Baumann, Reinhard, Prof. Dr., 82152 Krailling (DE); Walther, Thomas, 63067 Offenbach (DE); Hübler, Arved, Prof. Dr., 09120 Chemnitz (DE)
(74) Vertreter: Stahl, Dietmar

(57) **Zusammenfassung**

Die Erfindung betrifft ein Verfahren und Vorrichtungen zur Integration von elektronischen Bauteilen 2 auf leitfähige Bahnen 5, sowie entsprechende Elektronikbauteile. Verfahren und Vorrichtung sollen bei flexiblem Einsatz vereinfacht und kostengünstig anwendbar gestaltet werden.

Kennzeichnend für die Erfindung ist, dass das elektronische Bauteil 2 mit einer geringeren Präzision auf ein Drucksubstrat 1 oder Druckprodukt appliziert wird und in einem nachfolgenden Arbeitsgang mittels eines oder mehrerer Druckwerke Leiterbahnen 5 aufgedruckt werden, die durch Registerung des Druckwerks oder der Fördermittel zu dem vorab applizierten elektronischen oder funktionellen Bauelement ausgerichtet werden.

## Beschreibung

Die Erfindung betrifft ein Verfahren und eine Vorrichtung zur Applikation von elektronischen Bauelementen und Leiterbahnen in Druckprodukten oder für die Herstellung von Etiketten mit Transpondertechnologie und eine Elektronikbauelement nach den Patentansprüchen 1, 4 und 7.

Der Trend in der Verpackungs- und Drucksachenentwicklung geht eindeutig dahin Verpackungen und Druckprodukte nicht nur visuell ansprechend zu veredeln, sondern der Verpackung zusätzliche Funktionalitäten mitzugeben, die die Warenlogistik vereinfacht, den Fälschungsschutz oder die Produktsicherheit erhöhen und eine Interaktion des Verbrauchers mit dem Druckprodukt oder Verpackung erlauben. Das bekannteste, aber nicht einzige Beispiel hierfür ist die Transpondertechnik. Funktionalitäten können aber auch in das Druckprodukt durch einen Sensor, einen Schalter, einen Display oder einer Stromversorgung hinzugefügt werden.

Zur Verbindung der einzelnen Bauelemente untereinander werden Leiterbahnen benötigt. Die Transpondertechnik erforderte Antennen. Antennen und Leiterbahnen können mit leitfähigen Druckfarben gedruckt werden. Leitfähige Farben können metallgefüllte Druckfarben und / oder Druckfarben auf Basis von leitfähigen Polymeren sein.

Zur Herstellung von RFID-Etiketten (RFID≙ radio frequency identification device; RFID-Etikett ≙ Transpondertechnik) werden elektronische Bauelemente direkt oder elektronische Bauelemente auf einem Hilfsträger (Straps) einer Antenne zugeordnet als Bestandteil eines Transponders montiert .Dabei wird die Applikation der elektronischen Bauelemente auf einer kontinuierlich oder in diskreten Schritten fortbewegten Bahn durch einen Chip-Applikator vorgenommen. Der Chip-Applikator positioniert und befestigt die elektronischen Bauelemente oder die Hilfsträger mit darauf befindlichen elektronischen Bauelemente durch die bekannten Methoden des Klebens mit leitfähigen oder anisotropen Klebstoffen, mittels des so genannten Krimpens (durch mechanische Verankerung) oder durch Löten auf der Antenne. Antennen, als Bestandteil des Transponders, können auch durch die bekannte Methode des Ätzens, durch Präge- oder durch Druckverfahren auf das Substrat aufgebracht werden. Aus den Fertigungsmethoden von so genannten Smartcards ist ebenfalls bekannt Chips oder Baugruppen, die elektrische Funktionalitäten tragen, auf einzeln vorliegenden Druckprodukten zu befestigen.

Es ist auch aus Patentveröffentlichungen, zum Beispiel aus der WO 2005/078648, bekannt auf einen Druckbogen mit mehren Nutzen eine Vielzahl von Antennen zu drucken und den Druckbogen dann in einem dem Druckprozess nach gelagerten Verarbeitungsschritt, zum Beispiel einem Stanzvorgang, in einzelne Nutzen aufzutrennen und die auf den einzelnen Nutzen befindlichen Antennen danach in einer separaten Vorrichtung mit einem Chip oder einem Chip auf einem Hilfsträger (Strap) zu versehen.

Der Nachteil an dieser Technologie ist, dass der Chip oder der Chip auf dem Hilfsträger sehr exakt auf den Kontakten der Antenne positioniert werden müssen. Aus der RFID- bzw. Transpondertechnologie ist es bereits bekannt, dass auch ein nur geringer außermittiger Versatz des Chips relativ zur Antenne bei der Montage schon zu einer Verstimmung und Leistungseinbuße des RFID-Elementes bzw. Transponders führen können. Durch die erforderliche exakte Positionierung muss das Druckprodukt sehr exakt zugeführt werden und der Chip aufwendig positioniert werden. Die Positionierung des Chips oder des Chips auf einem Hilfsträger ist daher - schon alleine aufgrund der Baugröße - das die Leistung der Anordnung bestimmende Element bei der Herstellung von Druckprodukten mit RFID- bzw. Transpondertechnologie.
Eine zweite Leistungseinschränkung erfolgt dadurch, dass der Chip oder der Hilfsträger mit dem darauf befindlichen Chip eine enge Verbindung mit den Kontakten der Antenne eingehen müssen. Hierzu wird der Chip oder der Hilfsträger mit dem darauf befindlichen Chip mit einem leitfähigen Kleber oder einem anisotropen Kleber auf der Antenne befestigt. Dafür muss der Chip oder der Hilfsträger mit dem darauf befindlichen Chip unter Einsatz eines Haftvermittlers für eine gewisse Zeit gegen die Antennenkontakte gepresst werden. Diese Anforderung erschwert eine kostengünstige kontinuierliche Fertigung und verlangsamt ebenfalls den Prozess nicht unerheblich.

Damit ist, zumindest mit den heute bekannten Technologien, der Applikationsprozess eines Chips oder eines Chips auf einem Hilfsträger deutlich langsamer (bis zu einem Faktor 10) als andere Druck- und Weiterverarbeitungsprozesse in modernen Druckereien. Der Applikationsprozess kann dabei schnell zu einem Flaschenhals in der gesamten Produktion werden.

Aufgabe der Erfindung ist es daher ein schnelles und betriebssicheres Applikationsverfahren und Verbindungsverfahren für elektronische Bauelemente mit Leiterbahnen oder Antennestrukturen zu schaffen. Weiterhin gehören zur Aufgabenstellung die Schaffung einer geeigneten Vorrichtung und entsprechende Elektronikbauelemente zur Verarbeitung in solchen Vorrichtungen.

Gelöst wird dies durch ein Verfahren mit den Merkmalen der Patentanspruchs 1, durch Elektronikbauelemente gemäß den Merkmalen des Patentanspruchs 4 und durch eine Vorrichtung nach den Merkmalen des Patentanspruchs 7.

Sinnvolle Weiterbildungen ergeben sich aus den jeweiligen Unteransprüchen.

Kern der Erfindung ist es, ein elektronisches Bauelement auf einem Substrat, z.B. einem Bedruckstoff oder einem Druckbogen aufzubringen und durch einen der Applikation nachgeschalteten Druckvorgang leitfähig Verbindungen zu Schaltungen oder aber diese Schaltungen selbst in Kontakt zu den elektronischen Bauelementen herzustellen. Als Bauelemente kommen z.B. Chips für Transponder in so genannten RFID-Systemen in Frage.

Die absolute Positionierung des Transponders, bestehend zu mindestens aus einer Antenne und einem Chip, auf dem Druckprodukt kann in engen Grenzen variiert werden. Der Vorteil der RFID- bzw. Transpondertechnologie liegt bekanntlich darin, dass kein Sichtkontakt, wie bei dem Barcode, zu dem Lesegerät bestehen muss. Der Transponder kann daher zum Beispiel innerhalb einer Verpackung angebracht werden. Auch innerhalb eines RFID-Etiketts, das auch als Smart Label bezeichnet wird, spielt die absolute Lage des Transponders innerhalb der Grenzen des Etiketts keine Rolle.

Betrachtet man nun die exakte Applikation des Chips oder die Applikation eines Hilfsträgers mit einem Chip auf einer Antenne als den einen die Leistung bestimmenden oder die Leistung mindernden Faktor, so muss dieser Vorgang vereinfacht werden.
Ein erster Ansatz zur Vereinfachung des Applikationsverfahrens ist auf eine exakte Positionierung zu verzichten.
Ein weiterer Ansatz zur Vereinfachung des Applikationsvorgangs ist es auf die aufwendige Verklebung mit leitfähigen oder anisotropen Klebern mit den langen Einwirkzeiten zur Kontaktherstellung zwischen dem Chip oder dem Hilfsträger mit dem darauf befindlichen Chip zu verzichten.

Erfindungsgemäß wird dieser Ansatz zur Beschleunigung der Herstellungsverfahren eines Transponders gelöst, indem der Chip oder der Hilfsträger mit dem Chip direkt auf dem Bedruckstoff oder das Druckprodukt geklebt wird. Der Haftvermittler hat dabei nur die Funktion für eine ausreichende Anhaftung auf dem Bedruckstoff oder dem Druckprodukt zu sorgen. Nach der Applikation des Chips oder des Hilfsträgers mit dem darauf befindlichen Chip wird die Position des Chips oder des Hilfsträgers mit dem darauf befindlichen Chips durch ein Sensorsystem, vorzugsweise eine Kamera, ermittelt und ein nach dem Applikationsvorgang nach geordnetes Drucksystem oder Prägesystem für den Druck der Antennenstruktur so angesteuert, dass die Kontakte des Chips oder die Kontakte des Hilfsträgers so mit der leitfähigen Druckfarbe oder Prägefolie überdruckt werden, so dass ein Kontakt zwischen Chip oder Hilfsträger mit dem darauf befindlichen Chip und der Antennenstruktur gewährleistet ist.

Kennzeichnend dafür ist, dass das Druck- oder Prägesystem in Umfangs-, Seiten- oder Schrägregister dynamisch so verstellt werden kann, dass die Antenne in engen Grenzen winkel- und lagegenau in Bezug auf den vorab applizierten Chip oder Chip auf einem Hilfsträger gedruckt oder geprägt werden. Diese Verfahren lässt sich von der Herstellung von Transpondern leicht auf andere Anwendungen übertragen, die eine Verbindung mit einem elektronischen Bauteil mit einer Leiterbahn erfordern.

Durch die sehr geringe Positionierungsgenauigkeit des Chips oder des Hilfsträgers mit dem Chip, kann der Applikationsvorgang deutlich schneller erfolgen. Das Ziel eines höheren Durchsatzes wird durch die Reduzierung des Leistungsengpasses bei der Chipapplikation erreicht.

Die Erfindung wird im Folgenden anhand zeichnerischer Darstellungen näher erläutert.

Darin zeigt
- Figur 1: einen Hilfsträger für einen Chip,
- Figur 2: eine Positionierung für die Chipapplikation,
- Figur 3: eine Einrichtung mit Rollenzuführung,
- Figur 4: eine Variante der Einrichtung nach Fig. 3,
- Figur 5: eine weitere Variante der Einrichtung nach Fig. 3,
- Figur 6: eine Einrichtung mit Zuführung für Formatbogen und
- Figur 7: eine Variante der Einrichtung nach Fig. 6,

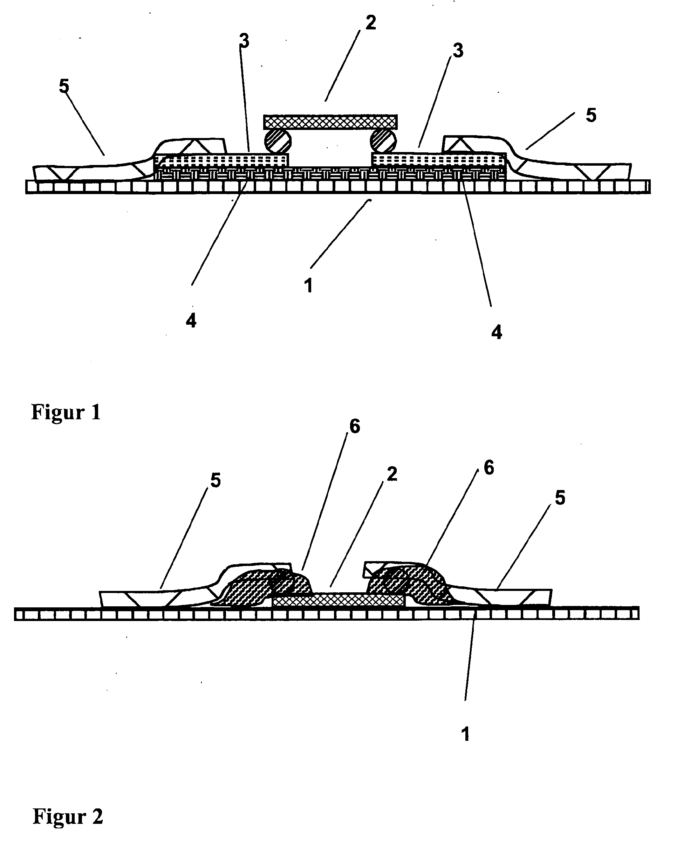

Figur 1 zeigt einen Hilfsträger 4, der auf einem Bedruckstoff 1 mit einem Haftvermittler oder in einer anderen geeigneten Art befestigt wurde, wobei der Hilfsträger 4 leitfähige Kontaktflächen 3 aufweist, die im Kontakt mit den Kontaktflächen des Chips 2 stehen. Über die Kontaktflächen 3 des Hilfsträgers 4 wurden dann in einem zweiten Arbeitsschritt leitfähige Strukturen 5 gedruckt oder geprägt, die bei einem RFID-Transponders Bestandteil einer Antenne sind.

Kennzeichnend dabei ist, dass die Kontaktflächen, im Gegensatz zur üblichen Vorgehensweise, sich nicht auf der Bedruckstoffseite befinden, sondern um eine Bedruckung zu ermöglichen auf der von der Bedruckstoffseite abgewandten Seite des Hilfsträgers mit Chip angeordnet ist.

Figur 2 zeigt die Situation für die Applikation eines einzelnen Chips, der sich nicht auf einem Hilfsträger befindet. Die Kontakte des Chips 2 können dabei dem Bedruckstoff 1 zugewandt oder abgewandt sein, bevorzugt wird dabei die Variante, bei der die Kontakte von dem Bedruckstoff 1 abgewandt sind. Gegebenfalls kann der Chip 2 mit einem leitfähigen Haftvermittler 6 auf dem Bedruckstoff fixiert sein. Über die Kontakte des Chips 2 und / oder, falls vorhanden, über die Schicht des leitfähigen Haftvermittlers 6 wird in einem dem Applikationsvorgang nachfolgenden Druckgang eine leitfähige Schicht 5 gedruckt, die Bestandteil einer Antenne oder einer Leiterbahn ist.

Das Druckwerk zum Drucken der leitfähigen Schichten 5 kann dabei ein Offset-, ein Flexo- oder ein Tiefdruckwerk sein. Es kann ebenfalls als ein rotatives Siebdruckwerk oder Flachbett-Siebdruckwerk sein. Ebenso kann das Druckwerk ein Non-Impact-Drucker, zum Beispiel ein Tintenstrahldrucker sein. Kennzeichnend für das Druckwerk ist, dass das Druckbild hochdynamisch von Drucknutzen zu Drucknutzen relativ zu dem Bedruckstoff im Längs-, Seiten- und Schrägregister verfahren werden kann, so dass das Druckbild passend zu dem zuvor applizierten Chip oder Hilfsträger mit Chip ausgerichtet werden kann.

Bei rotativen Drucksystemen kann dies erfolgen, in dem das gesamte Druckwerk sich auf einer Platte befindet, die durch schnelle Stelleinrichtungen verschoben wird. Das Längsregister kann beispielsweise sichergestellt werden, indem das gesamte Druckwerk oder der Formzylinder des Druckwerks mit einem Antrieb versehen wird, der sich hochdynamisch steuern lässt. Dadurch kann in Längsrichtung (Förderrichtung) der Druckbeginn frei gewählt werden. Die Seitenregistereinstellung kann auch erfolgen, indem mehrere Zylinder oder das gesamte Druckwerk seitlich verstellt werden. Das Schrägregister kann eingestellt werden; indem das Druckwerk oder einzelnen Zylinder oder Zylindergruppen seitlich mit schnellen Stellantrieben verschränkt werden. Bei nicht rotativen Drucksystemen, wie dem Flachbettsiebdruck oder dem Tintenstrahlkopf oder einem Array von Tintenstrahlköpfen werden diese ebenfalls mit schnellen Antrieben versetzt. Bei einem Array von Tintenstrahlköpfen kann die Anordnung des Druckbilds zu dem elektronischen Bauelement auch softwaretechnisch gelöst werden, indem die Düsen der Tintenstrahler so angesprochen werden, dass das Druckbild zum elektronischen Bauelement weitgehend immer gleich angeordnet ist.

Als Stellantriebe sind Piezoaktuatoren, Linearantriebe und jede andere geeignete Art von Aktuatoren denkbar. Das Längsregister kann in bewährter Form mit Einzelantrieben des Druckwerkes oder einzelner Zylinder erfolgen.

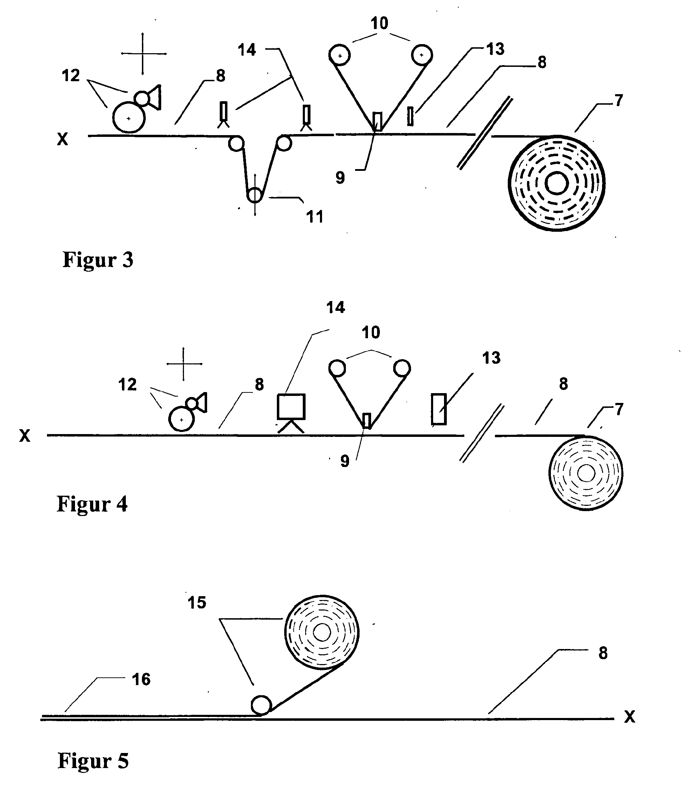

Figur 3 zeigt eine Einrichtung mit Rollenführung, bei der die Rollenbahn 8 von einer Vorratsrolle 7 abgerollt, gegebenenfalls anschließend bedruckt wird (nicht dargestellt) und dann gegebenenfalls einem Klebstoffspender 13 zugeführt wird, der die Bahn mit einem Haftvermittler für die Anhaftung des Chips 2 oder des Hilfsträgers 4 mit dem darauf befindlichen Chip 2 sorgt. Alternativ kann auch das Hilfsträgerband 10 mit den darauf befindlichen Chips 2 mit einem Haftvermittler versehen werden oder sein. Anschließend wird die Rollenbahn der Applikatoreinrichtung 9 zugeführt, die den Chip 2 oder den Hilfsträger 4 mit dem darauf befindlichen Chip 2 auf der Rollenbahn ablegt bzw. befestigt. Danach wird die Lageposition des applizierten Chips 2 oder des Hilfsträgers durch einen oder mehrere geeigneten oder geeignete Sensor 14 bzw. Sensoren 14 detektiert. Ein geeigneter Sensor 14 könnte zum Beispiel ein Kamerasystem sein. In dem Ausführungsbeispiel gemäß Fig. 1 erfolgt die Längspositionierung des Druckwerks 12 relativ zu der ermittelten Chipposition, durch eine Tänzerwalze 11 oder eine Tänzerwalzengruppe. Durch die Tänzerwalzenbewegung 11 wird der Chip auf der Rollenbahn 8 in Transportrichtung so positioniert, dass die Leiterbahnen 5 oder Antennenbahnen 5 an den vorgesehenen Stellen mit dem Chip 2 oder mit dem Hilfsträger 4 mit dem darauf befindlichen Chip 2 in Kontakt kommen. Das Schräg- und Seitenregister kann in bekannter Form oder durch schnelle Stellantriebe im Druckwerk 12 eingestellt werden.

Figur 4 zeigt ein weiteres Ausführungsbeispiel, wobei auf die Längsregisterverstellung mittels Tänzerwalze 11 verzichtet wurde. In diesem Ausführungsbeispiel kann das Längsregister zum Beispiel durch einen Einzelantrieb des Druckwerkes 12 realisiert werden.

An die Lösungen zur Erstellung eines Transponders auf einer Rollenbahn 8, wie sie in Fig. 3 und Fig. 4 dargestellt wurden, können sich weitere Arbeitsschritte anschließen. Die Rollenbahn 8 kann in Abschnitte eingeteilt, gestanzt, gerillt, gefalzt oder wieder aufgerollt werden. In Fig. 5 ist dargestellt wird die Rollenbahn 8 mit dem darauf befindlichen Transponder mit einer weiteren Rollenbahn 16 zusammengeführt und verbunden. Die zusätzliche Rollenbahn 16 wird dabei von einer Abwicklungsstation 15 mit Vorratsrolle abgerollt und mit der zugeführten Rollenbahn 8 mit dem darauf befindlichen Transponder in geeigneter Weise zusammengeführt und verbunden. Die zusätzliche Rollenbahn 16 dient zum Schutz der darunter liegenden Transponder. Sie kann mit Informationen bedruckt sein oder aus einer unbedruckten Rollenbahn bestehen.

Die Erfindung sieht auch Vorrichtungen vor, die Transponderbestandteile auf einen Formatbogen aufbringen. Formatbögen im Sinne der Erfindung können Druck- oder Papierbögen, Faltschachtelzuschnitte, gefalzte und / oder geheftete Produkte, Bücher oder Folien sein. Im Sinne der Erfindung umfasst der Begriff Formatbogen alle Drucksubstrate und Druckprodukte, die nicht als Rollenbahn vorliegen.

Als erfindungsgemäße Fördermittel werden umlaufende Bänder (mit und ohne Saugwirkung), Greiferwagen, Schlitten, Ketten, Saugerbänder, Klettbänder oder ähnliche Vorrichtungen gezählt, die es ermöglichen einen Formatbogen über eine Strecke zu transportieren.

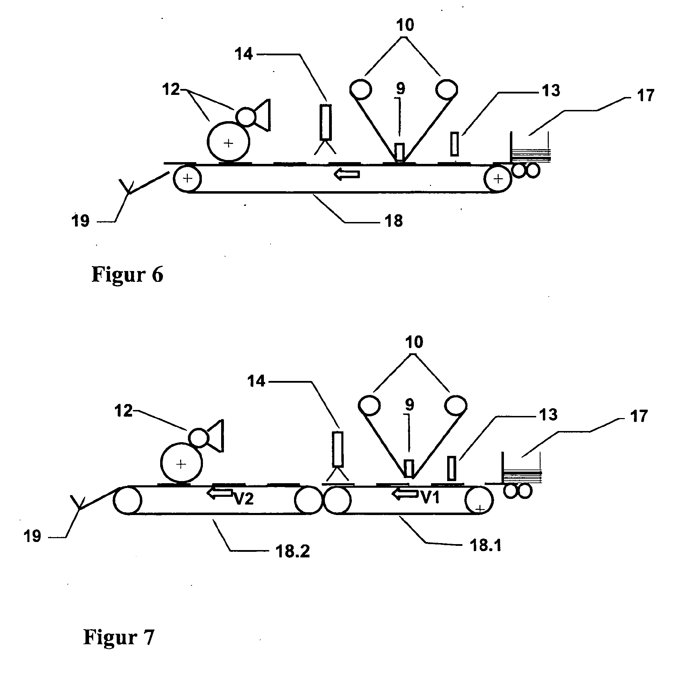

Dabei wird, wie in Fig. 6 dargestellt, der Formatbogen im Sinne der Erfindung von einem Einleger oder Anleger 17 auf ein Fördermittel, hier dargestellt als ein umlaufendes Band 18 abgelegt, und als erstes gegebenenfalls einem Klebstoffspender zugeführt 13, der den Haftvermittler für die Fixierung des Chips 2 oder des Hilfsträgers 4 mit Chip 2 auf den Formatbogen aufbringt. Alternativ kann der Chip 2 oder der Hilfsträger 4 vor dem Aufspenden mit einer Haftvermittlerschicht versehen werden. Nach diesem Arbeitsschritt kommt der erfindungsgemäße Formatbogen zu einer Applikatorvorrichtung 9, die den Chip 2 oder den Hilfsträger 4 mit Chip 2 auf den Formatbogen aufspendet. Als nächster Arbeitsschritt wird die Position des Chips 2 oder des Hilfsträgers 4 mit Chip 2 auf dem Formatbogen durch ein geeignetes Sensorsystem 14 bestimmt. Das Sensorsystem 14 ist in einer bevorzugten Ausführung eine Kamera. Danach wird der erfindungsgemäße Formatbogen einem Druckwerk 12 zugeführt, das eine Umfangs-, Seiten- und Schrägregisterverstellung hoch dynamisch von Formatbogen zu Formatbogen erlaubt. Kennzeichnend für den Fluss der Formatbogen der Lösung gemäß Fig. 6 ist weiterhin, dass der Abstand zwischen den einzelnen Formatbogen weitgehend äquidistant ist.

In Fig. 7 wird das Fördermittel 18 in zwei Teilbereiche (18.1 und 18.2) aufgeteilt, hier dargestellt durch zwei voneinander getrennte umlaufende Bänder. Nach Applikation des Chips 2 oder Hilfsträger 4 mit Chip 2 auf den erfindungsgemäßen Formatbogen mittels der Applikatorvorrichtung 9, wird die Lage des Chips 2 oder des Hilfsträgers 4 mit Chip 2 auf dem erfindungsgemäßen Formatbogen identifiziert und die gewonnen Werte zur Ansteuerung des zweiten Fördermittelabschnittes 18.2 genutzt. Durch die Einstellung der Fördergeschwindigkeit des zweiten Fördermittels 18.2 kann der Formatbogen früher oder später der Druckvorrichtung 12 zugeführt werden. Dadurch können Positionierfehler des Chips 2 oder des Hilfsträgers 4 mit Chip 2 in Förderrichtung ausgeglichen werden. Die seitliche Anpassung des Druckwerkes 12 erfolgt mittels einer hochdynamischen Anpassung des Seiten- und Schrägregisters. Kennzeichnend für diese Ausführung ist, dass die Formatbogen über die Förderstrecke nicht in äquidistanten Abständen vorliegen müssen und variable Bogenabstände aufweisen können.

Die Erfindung wurde anhand einer Lösung für den RFID-Bereich erläutert. Das applizierte elektronische Bauelement muss nicht zwingend ein Chip 2 sein. Alternativ kann es auch ein Sensor, ein Display, eine Batterie, ein logischer Baustein oder ein Schalter sein. Die Verfahrensweise der einzelnen vorgestellten Varianten bleibt dabei gleich, nur wird anstelle des Chips 2 ein anderer elektronsicher Baustein oder ein Element, der eine leitfähige Anbindung benötigt, appliziert.

### Bezugszeichenliste

- 1: Bedruckstoff
- 2: Chip
- 3: Kontaktfläche
- 4: Hilfsträger
- 5: Leitfähige gedruckte Schicht
- 6: Leitfähiger oder anisotroper Kleber
- 7: Vorratsrolle
- 8: Rollenbahn
- 9: Applikator
- 10: Vorratsrolle für Hilfsträgerband
- 11: Tänzerwalze
- 12: Druckvorrichtung
- 13: Klebstoffspender
- 14: Sensor
- 15: Abwickeleinrichtung Deckbahn
- 16: Deckbahn
- 17: Einleger / Anleger
- 18: Fördermittel
- 18.1: Teilabschnitt Fördermittel
- 18.2: Teilabschnitt Fördermittel
- 19: Ausleger / Abstapler

## Patentansprüche

1. Verfahren zur Applikation von elektronischen Bauelementen und Leiterbahnen in Druckprodukten oder für die Herstellung von Etiketten mit Transpondertechnologie mittels einer Vorrichtung zum Zuführen von elektronischen Bauelementen zu einem Substrat oder Druckprodukt,
**dadurch gekennzeichnet,**
**dass** ein eine elektronische Schaltung enthaltendes Elektronikbauelement (2) oder ein Hilfsträger (4) mit einem Elektronikbauelement (2) direkt auf einem Bedruckstoff (1) oder ein Druckprodukt verklebt wird, dass nach Applikation des Elektronikbauelements (2) oder des Hilfsträgers (4) mit dem Elektronikbauelement (2) die Position des Elektronikbauelements (2) oder des Hilfsträgers (2) mit dem Elektronikbauelement (4) durch ein Sensorsystem (14), vorzugsweise eine Kamera, ermittelt und dass ein dem Applikationsvorgang nach geordnetes Drucksystem (12) oder Prägesystem für den Druck einer leitenden oder Antennenstruktur so angesteuert wird, dass die Kontakte des Elektronikbauelements (2) oder die Kontakte des Hilfsträgers (4) so mit einer leitfähigen Druckfarbe oder Prägefolie überdruckt werden, dass ein vollständiger elektrischer Kontakt zwischen dem Elektronikbauelement (2) oder Hilfsträger (4) mit dem Elektronikbauelement (2) und der leitfähigen Struktur (5) oder Antennenstruktur gewährleistet ist.

2. Verfahren nach Anspruch 1,
**dadurch gekennzeichnet,**
**dass** das Druck- (12) oder Prägesystem in Richtung eines Umfangs-, Seiten- oder Schrägregister dynamisch verstellbar ist, dass die leitfähige Struktur (5) oder Antennenstruktur in engen Grenzen winkel- und lagegenau in Bezug auf den vorab applizierten Elektronikbauelement (2) oder Elektronikbauelement (2) auf einem Hilfsträger (4) gedruckt oder geprägt wird.

3. Verfahren nach Anspruch 1,
**dadurch gekennzeichnet,**
**dass** es zur Herstellung von elektrisch leitenden Verbindungen eines elektronischen Bauteils (2) mit einer Leiterbahn verwendet wird.

4. Elektronikbauelement auf einer tragenden Unterlage,
**dadurch gekennzeichnet,**
**dass** eine elektronische Baugruppe (2) oder die elektronische Baugruppe (2) auf einem Hilfsträger (4) leitfähige Kontaktflächen aufweist, die im Kontakt mit den Kontaktflächen der elektronischen Baugruppe (2) stehen und dass über die Kontaktflächen der elektronischen Baugruppe (2) oder des Hilfsträgers (4) leitfähige Strukturen gedruckt oder geprägt sind, die Bestandteil einer Leiterbahn, einer Antenne oder einer anders gearteten elektrische oder elektronischen Einheit sind.

5. Elektronikbauelement nach Anspruch 4,
**dadurch gekennzeichnet,**
**dass** die Kontaktflächen der elektronischen Baugruppe (2) oder des Hilfsträgers (4) auf der von der Bedruckstoffseite abgewandten Seite der elektronischen Baugruppe (2) oder des Hilfsträgers (4) mit der elektronischen Baugruppe (2) angeordnet sind.

6. Elektronikbauelement nach Anspruch 5,
**dadurch gekennzeichnet,**
**dass** die elektronische Baugruppe (2) mit einem leitfähigen Haftvermittler auf dem Bedruckstoff (1) fixiert ist.

7. Vorrichtung zur Herstellung einer elektronischen Baugruppe,
**dadurch gekennzeichnet,**
**dass** ein Transportsystem (18) für einen Bedruckstoff in Verbindung mit elektronischen Bauelementen (2) oder in Verbindung mit auf Hilfsträgern (4) angeordnete elektronische Bauelemente (2) vorgesehen ist, dass im Transportweg des Transportsystems (18) wenigstens ein Druckwerk (12) zum Drucken einer oder mehrere leitfähiger Schichten in Verbindung mit den elektronischen Bauelementen (2) angeordnet ist, und dass das Druckwerk (12) nach dem Verfahren des Offset-, ein Flexo-, Sieb- oder Tiefdruckes arbeitet oder als Non-Impact-Drucker ausgebildet ist.

8. Vorrichtung nach Anspruch 7,
**dadurch gekennzeichnet,**
**dass** das Druckwerk (12) mit Einrichtungen versehen ist, mittels derer das Druckbild hochdynamisch von Drucknutzen zu Drucknutzen relativ zu dem Bedruckstoff (1) hinsichtlich seines Längs-, Seiten- und Schrägregisters verfahrbar angeordnet ist.

9. Vorrichtung nach Anspruch 7,
**dadurch gekennzeichnet,**
**dass** in dem Druckwerk (12) Mittel vorgesehen sind, mittels derer das im Druckwerk (12) aufzubringende Druckbild passend zu einem zuvor applizierten elektronischen Bauelement (2) oder Hilfsträger (4) mit elektronischem Bauelement (2) ausgerichtet werden kann.

10. Vorrichtung nach Anspruch 7 bis 9,
**dadurch gekennzeichnet,**
**dass** zur Herstellung von elektronischen Baugruppen ein rotatives Drucksystem vorgesehen ist, in dem ein Druckwerk (12) als Baueinheit auf einer Plattform angeordnet ist, und dass die Plattform durch schnelle Stelleinrichtungen relativ zur Lage des Bedruckstoffes verschiebbar ist.

11. Vorrichtung nach Anspruch 7 bis 9,
**dadurch gekennzeichnet,**
**dass** zur Herstellung von elektronischen Baugruppen ein rotatives Drucksystem vorgesehen ist, in dem Teile eines Druckwerkes (12) relativ zueinander verstellbar und durch schnelle Stelleinrichtungen relativ zur Lage des Bedruckstoffes (1) verschiebbar angeordnet ist.

12. Vorrichtung nach Anspruch 10 oder 11,
**dadurch gekennzeichnet,**
**dass** als Stellantriebe Piezoaktuatoren, Linearantriebe und jede andere geeignete Art von Aktuatoren verwendet werden.

13. Vorrichtung nach Anspruch 10 oder 11,
**dadurch gekennzeichnet,**
**dass** als Stellantriebe für das Längsregister Einzelantriebe des jeweiligen Plattenzylinders eines Druckwerkes (12) oder einzelner Zylinder vorgesehen sind.

14. Vorrichtung nach Anspruch 7 bis 13,
**dadurch gekennzeichnet,**
**dass** eine Einrichtung mit einer Rollenzuführung einer Bedruckstoffbahn (1) vorgesehen ist, von der die Bedruckstoffbahn (1) einem Druckwerk (12) zuführbar ist, dass in der Bahnführung weiterhin ein Klebstoffspender (13) vorgesehen ist, um einen Haftvermittler positionsgenau auf die Bedruckstoffbahn (1) aufzutragen, so dass mittels des Haftvermittlers eine Anhaftung von elektronischen Bauelementen (2) oder Hilfsträgern (4) mit elektronischen Bauelementen (2) positionsgenau auf der Bedruckstoffbahn (1) vorgenommen wird.

15. Vorrichtung nach Anspruch 7 bis 13,
**dadurch gekennzeichnet,**
**dass** zur Erfassung der Lageposition des auf dem Bedruckstoff (1) applizierten elektronischen Bauelements (2) oder des Hilfsträgers (4) mit dem elektronischen Bauelement (2) ein oder mehrere Sensoren (14) vorgesehen sind und dass die Stelleinrichtungen zur Positionierung des Bedruckstoffes (1) in Abhängigkeit von den Messwerten der Sensoren (14) ansteuerbar sind.

16. Vorrichtung nach Anspruch 15,
**dadurch gekennzeichnet,**
**dass** zur Erfassung der Lageposition eines applizierten elektronischen Bauelements (2) vorzugsweise ein Kamerasystem verwendet wird.

17. Vorrichtung nach Anspruch 15 oder 16,
**dadurch gekennzeichnet,**
**dass** die Positionierung eines Druckwerks (12) in Laufrichtung zum Bedruckstoff (1) relativ zu der ermittelten Position der elektronischen Bauelemente (2) durch eine Tänzerwalze (11) oder eine Tänzerwalzengruppe erfolgt.

18. Vorrichtung nach Anspruch 7 bis 17,
**dadurch gekennzeichnet,**
**dass** in Transportrichtung des Bedruckstoffes (1) anschließend an Druckwerke (12) zum Drucken von Antennen oder Leiterbahnen in Verbindung mit aufgeklebten elektronischen Bauelementen (2) Einrichtungen zum einteilen, stanzen, rillen, falzen oder aufrollen angeordnet sind.

19. Vorrichtung nach Anspruch 7 bis 18,
**dadurch gekennzeichnet,**
**dass** Einrichtungen (10) zur Aufbringung von Transponder-Bestandteilen auf einen Formatbogen (1) vorgesehen sind, wobei als Formatbögen (1) Druck- oder Papierbögen, Faltschachtelzuschnitte, gefalzte und / oder geheftete Produkte, Bücher oder Folien vorgesehen sind.

20. Vorrichtung nach Anspruch 7 bis 19,
**dadurch gekennzeichnet,**
**dass** als Fördermittel (18) umlaufende Bänder mit und ohne Saugwirkung, Greiferwagen, Schlitten, Ketten, Saugerbänder, Klettbänder oder ähnliche Vorrichtungen verwendet werden.
